# EUROPÄISCHE PATENTSCHRIFT

(11) **EP 1 138 118 B1**
(45) Veröffentlichungstag und Bekanntmachung des Hinweises auf die Patenterteilung: **28.04.2010**
(21) Anmeldenummer: 99973365.2
(22) Anmeldetag: 08.12.1999
(51) Int. Cl.: H03K 17/95, G01R 27/02

(54) **VERFAHREN UND VORRICHTUNG ZUR MESSUNG DER DÄMPFUNG EINES LC-SCHWINGUNGSKREISES**
METHOD AND DEVICE FOR MEASURING THE DAMPING OF A LC-OSCILLATING CIRCUIT
PROCEDE ET DISPOSITIF PERMETTANT DE MESURER L'AMORTISSEMENT D'UN CIRCUIT OSCILLANT LC

(30) Priorität: 08.12.1998 CH 243298
(43) Veröffentlichungstag der Anmeldung: 04.10.2001
(73) Patentinhaber: Baumer Innotec AG, 8500 Frauenfeld (CH)
(72) Erfinder: GUGGENBÜHL, Walter, CH-8712 Stäfa (CH); HUG, Benjamin, CH-8180 Bülach (CH); BRÄNDLE, Daniel, CH-8580 Amriswil (CH)
(74) Vertreter: Frei, Alexandra Sarah
(86) Internationale Anmeldenummer: PCT/CH1999/000593
(87) Internationale Veröffentlichungsnummer: WO 2000/035092

(56) Entgegenhaltungen:
- US-A- 4 001 718
- US-A- 5 767 672
- TIETZE U ET AL: "FET-DIFFERENZVERSTAERKER" HALBLEITER - SCHALTUNGSTECHNIK, Seiten 97-99, XP002042673 TIETZE U;SCHENCK C

## Beschreibung

Die vorliegende Erfindung betrifft eine verbesserte Vorrichtung zur Messung und Steuerung der Dämpfung eines elektrischen LC-Schwingungskreises.

Zahlreiche technische Messverfahren beruhen auf der Bestimmung der Dämpfung von LC-Schwingungskreisen. Die Messung und Steuerung des entsprechenden äquivalenten Dämpfungswiderstandes des LC-Kreises ist deshalb ein zentrales Problem vieler elektronischer Geräte. Als Beispiel der sich dabei stellenden Probleme und zur Illustration des neuen, erfindungsgemässen Verfahrens dient in der Folge eine Vorrichtung zur Bestimmung der Distanz bezüglich eines elektrisch leitenden Objekts auf Grund der Bedämpfung eines elektrischen LC-Schwingungskreises. Auf diesem Prinzip beruhende Vorrichtungen werden in der Industrie, vorzugsweise als Distanzschalter, verbreitet eingesetzt.

Die Genauigkeit bezüglich der Mess- bzw. Schaltdistanz wird weitgehend durch die zur Anregung der LC-Kreises verwendeten Oszillatorschaltung bestimmt. In dieser wird dann eine distanzabhängige Gleichstromgrösse gebildet und diese, im Falle eines Distanzschalters, über eine Schwelle zur Steuerung eines Schalters verwendet. Ein Hauptproblem ist dabei die Temperaturkonstanz des Schaltpunkts und dessen Abhängigkeit von den Toleranzen der verwendeten Schaltelemente und des Gehäuseeinbaus, was einen Abgleich nach erfolgter Herstellung erfordert.

Aus Kostengründen ist die Auswahl unter den vielfältigen bekannten Oszillatorstrukturen und Abgleichmöglichkeit nach der Fertigung (z.B. durch Laser-Trimmen) beschränkt.

Dem erfindungsgemäss verbesserten Verfahren liegt ein neuartiges Oszillatorkonzept zugrunde das die folgenden Merkmale kombiniert erfüllt:
- temperatur- und toleranzunabhängige Grundschaltung zur Anregung des LC-Kreises
- von der Grundschaltung unabhängig einstellbare Kompensation der Temperaturabhängigkeit des LC-Kreises
- "elektronischer" Abgleich der Fabrikationstoleranzen nach erfolgter Fertigung
- 2-Draht-Oszillator (keine Spulenmittelabgriffe)
- Monochip-lategration aller Funktionen.

Den Kern einer LC-Oszillatorstruktur bildet im allgemeinen ein rückgekoppelter Verstärker. Erfolgt die Rückkopplung "in Phase" und ist die Kreisverstärkung grösser als eins so schwingt die Schaltung mit einer durch den LC-Kreis festgelegten Frequenz an. Die Amplitude der entstehenden Schwingung wird bei einfachen Oszillatoren neben einer Abhängigkeit von der Schwingkreisdämpfung vor allem durch eine sog. Nichtlinearität bestimmt, z.B. indem die Grenze des Aussteuerungsbereichs erreicht wird, was eine weitere Zunahme der Schwingspannung verunmöglicht. Durch diese von der Kreisdämpfung abhängige Übersteuerung werden die Arbeitspunktsströme der Schaltung verändert; diese Veränderung kann als Mass für die Schwingkreisdämpfung und damit für die Distanz verwendet werden.

Als Alternative zu dieser Methode bietet sich die Regelung der Schwingamplitude auf einen fixen Wert mittels linearer Regelung des Verstärkungsfaktors des Anregungsverstärkers an, wobei die Regelgrösse ein Mass für die Schwingkreisdämpfung ist.

Solche Schaltungstypen eignen sich jedoch nur sehr beschränkt zur Erfüllung der oben aufgestellten kombinierten Merkmale und zwar aus folgenden Gründen:
- die Ableitung der Distanzinformation aus einer mehr oder weniger undefinierten Mischung von Schwingkreisdämpfung und Schwingbereichs-Übersteuerung, wie sie in einfachen Oszillatoren stattfindet, eignet sich, weil theoretisch schwer beschreibbar, nicht für hochpräzise und digital trimmbare Oszillatoren;
- die Methode mit geregelter Schwingamplitude weist eine zu grosse Trägheit (bei fahrenden Messköpfen) auf. Ebenso scheidet die Ausnützung des dämpfungsabhängigen Schwingungseinsatzes als Distanzschaltkriterium aus Geschwindigkeitsgründen aus.

Die US-Patentschrift 4 001 718 offenbart eine Vorrichtung zur Messung der Distanz von einem elektrisch leitenden Objekt mittels Dämpfung eines LC-Schwingungskreises, wobei der Schwingungskreis an eine Anregungsschaltung angeschlossen ist, die eine Spannung erzeugt, welche proportional ist zum effektiven Dämpfungswiderstand des Schwingungskreises und zu einem Steuerstrom. Diese Vorrichtung hat den Nachteil, dass Schwankungen bei der Erzeugung des Steuerstroms in das Messresultat eingehen.

Die Erfindung stellt sich daher die Aufgabe, eine Schaltungsstruktur zu schaffen, mit der die oben erwähnten Anforderungen erfüllt sind und die Nachteile der alternativen Methoden überwindet.

Die Forderung nach einer 2-Draht Spule ohne Mittelabgriff wird durch einen zweistufigen Anregungsverstärker erfüllt. Solche Schaltungen sind in der Literatur vorgeschlagen. Diese Schaltungen weisen jedoch nur eine geringe Aussteuerbarkeit auf und sind ausserdem für CMOS Technik ungeeignet. Um diesen Nachteil zu umgehen kann man solche Schaltungstypen erfindungsgemäss erweitern, wie dies im Zusammenhang mit der Figurendiskussion weiter unten im Detail dargelegt ist.

Die unten aufgeführten Figuren zeigen folgendes:
- Figur 1: zeigt eine bekannte Schwingschaltung von welcher aus die erfindungsgemässen Erweiterungen aufgezeigt werden.
- Figur 2: zeigt ein Beispiel einer Erweiterung zur erfindungsgemässen Schaltung.
- Figur 3: zeigt eine weitere beispielshafte Erweiterung der Schaltung gemäss Figur 2 zur erfindungsgemässen Schaltung.
- Figur 4: zeigt die vereinfachte Darstellung der Schaltung gemäss Figur 3 mittels eines sogenannten Oszillatorkerns.
- Figur 5: zeigt ein Beispiel für eine Oszillatorschaltung zur Schaltung nach Figur 4.
- Figur 6: zeigt ein Beispiel wie der Schaltungsabgleich durchgeführt werden kann.
- Figur 7: zeigt ein Beispiel für die Erzeugung eines Korrekturstroms mittels eines D/A-Wandler.

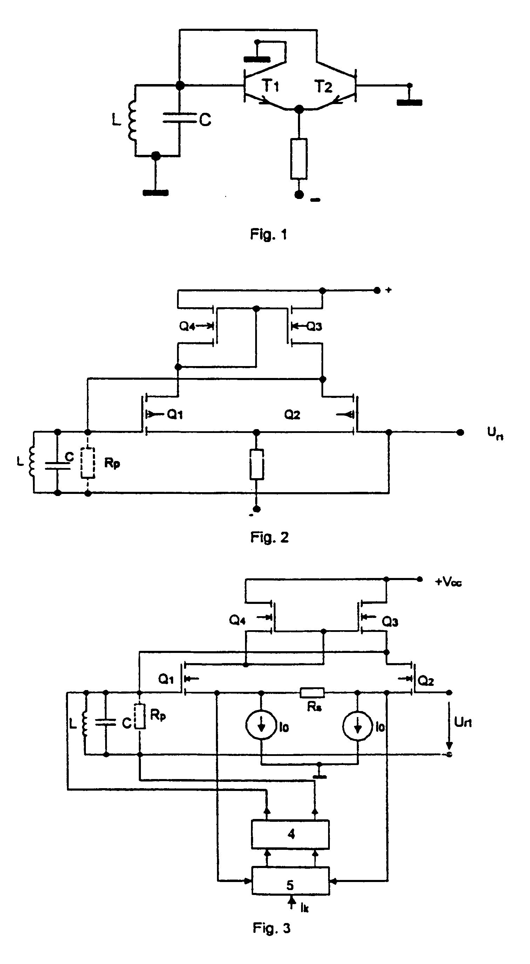

**Figur 1** zeigt eine bekannte Schwingschaltung mit nur zwei Anschlussdrähten des LC-Kreises mit einem zugeschalteten, durch die Transistoren T1 und T2 gebildeten, zweistufigen Anregungsverstärker (nach U. Tietze, Ch. Schenk, Halbleiterschaltungstechnik, Springer, Fünfte Auflage, S. 425). Die Schaltung gemäss Fig. 1 weist nur eine geringe Aussteuerbarkeit auf und würde als solche den angestrebten Zweck nicht erfüllen und ist ausserdem, wie oben schon erwähnt, für CMOS Technik ungeeignet. Sie wurde deshalb erfindungsgemäss zunächst um einen Stromspiegel erweitert, wie dies Figur 2 zeigt. Durch Zufügen des Stromspiegels mit den MOS-Transistoren Q3, Q4 und einer zusätzlichen Speisequelle (U_{R1}) erreicht man eine grössere Aussteuerbarkeit und durch den Einsatz von MOS-Transistoren die Eignung für die Ausführung in CMOS-Technik. Mit Rp ist ein von der Messdistanz abhängiger, äquivalenter Bedämpfungswiderstand des Parallelschwingkreises bezeichnet (in der Praxis realisiert durch eine elektrisch leitendes Objekt im Wirkungsbereich des Magnetfeldes der Spule, bspw. ein Phantomteil). Die MOS-Transistoren Q1 und Q2 sind äquivalent zu den Transistoren T1 und T2 in Figur 1.

Das nachstehend angegebene und an Schaltungsbeispielen diskutierte Verfahren beruht auf Anregung eines Schwingkreises mit einem rechteckförmigen Strom bzw. Strömen, deren Grösse durch die in die Schaltung eingespeisten Gleichströme bestimmt werden. Dadurch entsteht eine Schwingspannung, die proportional zur Grösse der Ströme und dem effektiven Dämpfungswiderstand des Schwingkreises ist, weil der Schwingkreis die Grundharmonische aus den Anregungsströmen aussiebt.

Die Steuerung des effektiven Dämpfungswiderstandes kann durch Änderung des eingespeisten Gleichstromes erzielt werden. Dies erreicht man durch Zusatzströme zum eingespeisten Gleichstrom.

Beispielsweise werden Zusatzströme in geeigneter Grösse zur Steuerung dem Hauptstrom zugefügt oder in einer weiteren, bevorzugten Ausführung werden die Zusatzströme mittels eines Zerhackers zerhackt und dem Schwingkreis in der geeigneten Phasenlage (bspw. über einen Polwender) zugeführt.

Durch geeignete Wahl der Phasenlage können positive und negative Korrekturen des effektiven Dämpfungswiderstandes Rp erreicht werden.

**Figur 3** zeigt zur Durchführung des oben angegebenen Verfahrens eine Erweiterung der Schaltung gemäss Figur 2 in Richtung (ausschliesslicher) Anfachung des Schwingkreises LC durch rechteckige Ströme Io, wodurch die Proportionalität der Schwingamplitude zu Rp und dem steuerbaren Strom Io erzielt wird. Die Schaltung ist schwingfähig, wenn Rs kleiner Rp gewählt wird. Zur beispielsweisen Vereinfachung sind in Figur 3 für die Schalter nur einfache Transistoren gezeichnet und die steuerbaren Ströme Io durch entsprechende Quellensymbole dargestellt. In der Praxis werden die MOS-Transistoren durch kompliziertere Strukturen, z.B. durch mehrere MOS-Transistoren ersetzt und die Stromquellen mittels Kaskoden realisiert. Nach dem Anschwingen arbeiten die beiden Transistoren Q1 und Q2 als Schalter, wobei der Schwingkreis ausschliesslich durch die beiden Stromquellen Io angeregt wird. Ein zusätzlicher Steuerstrom Ik wird einem Zerhacker 5 und von dort einem programmierbaren Polwender 4 zugeleitet, um einen rechteckigen Korrekturstrom zu erzeugen, mit dem der Schwingkreis LC gesteuert wird.

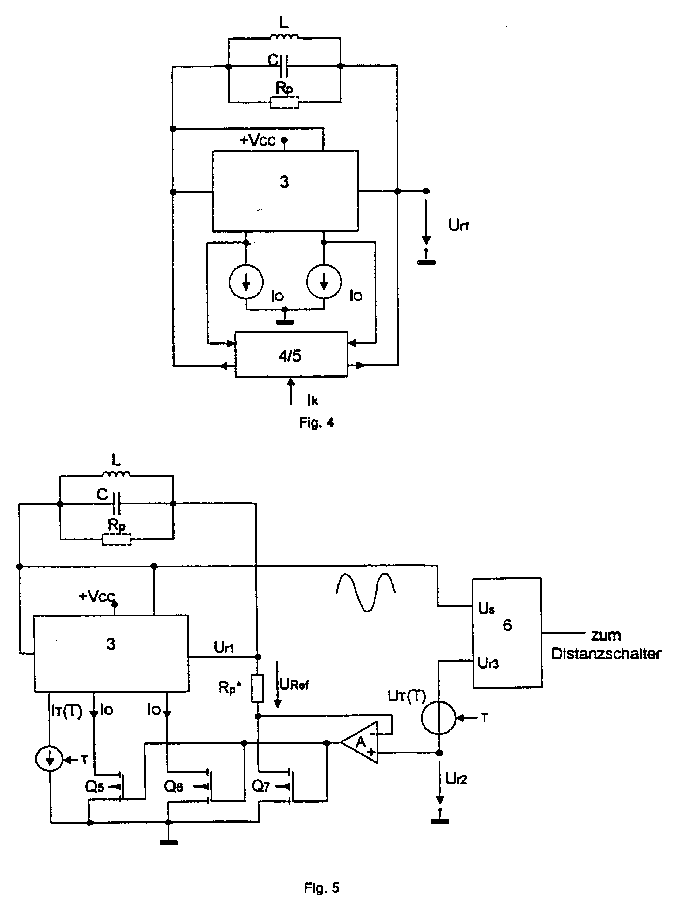

**Figur 4** zeigt nun die vereinfachte Darstellung der Schaltung gemäss Figur 3 mit Hilfe eines Oszillatorkerns 3, wie er hier bezeichnet wird. Er umfasst die Schaltungsteile gemäss Figur 3 ohne den Schwingungskreis LC und Stromquellen Io. Die Schwingamplitude der Schaltung wird im Idealfall proportional zu Rp (dem Bedämpfungswiderstand im Magnetfeld des Schwingungskreises) und zu den Stromquellen Io.

Bei Verwendung als Distanzschalter wird die Schwingkreisamplitude mit einem Referenzwert U_{REF} verglichen (siehe Fig. 5) und das Resultat (die Differenz bzw. Polarität) zur Betätigung eines elektrischen oder elektronischen Schalters verwendet. In der erfindungsgemässen Vorrichtung wird der Spannungs-Referenzwert U_{REF} konstant gehalten und der gewünschte Schaltpunkt über den Stromwert Io eingestellt. Durch Ableitung des Stromes Io über einen Widerstand aus der Referenzspannungsquelle U_{REF} = Url-Ur2 folgt Io und damit die Schwingamplitude Us allfälligen Änderungen von Uref nach. Der Spannungsvergleich wird damit unabhängig vom Absolutwert von U_{REF}.

**Figur 5** zeigt die entsprechende Oszillatorschaltung unter Bezugnahme von Figur 4 (ohne Schaltungszusatz zur Zerhackung der Korrekturströme) mit Ableitung der Steuerstromquellen Iₒ via einem bspw. zuschaltbaren Widerstand Rp* aus einer Referenzspannung U_{REF}. Die Transistoren Q5 und Q6 entsprechen den Stromquellen Io der Figuren 3 und 4. Sie sind in Praxis als Kaskoden aufgebaut. Ein Spannungsvergleicher 6 vergleicht die Schwingamplitude Us mit der Spannung Ur3 = Ur2 + U_{T}(T) wenn T gleich Temperatur und deren Differenz betätigt einen nachfolgenden Distanzschalter. Bei hoher Verstärkung des ableitenden Verstärkers A wird (Ur2-Ur3) gleich U_{REF} und der Strom durch Rₚ* und Q7 gleich U_{REF}/Rp*. Durch Stromspiegelung von Q7 auf Q5 und Q6 werden auch die Ströme Io proportional zu U_{REF} und die Schwingamplitude Us folgt allfälligen Änderungen von U_{REF} nach.

Die auf dem Chip erzeugte temperaturabhängige Spannungsquelle U_{T}(T) am Komparatoreingang dient zur Kompensation des Temperaturgangs des Dämpfungswiderstandes Rp des Schwingungskreises. Alternativ kann ein Teilstrom I_{T}(T) oder der ganze, die Schwingamplitude bestimmende Steuerstrom temperaturabhängig gemacht werden. Gegebenenfalls kann die Temperaturkompensation digital eingestellt werden. Der durch die Fabrikationstoleranzen bedingte Abgleich des Schaltpunkts nach erfolgter Herstellung erfolgt durch Addition eines entsprechenden einstellbaren, kleinen Zusatzstroms Ik zum Strom Io. Ik wird analog Io aus der Referenzspannung abgeleitet. Um beide Vorzeichen dieser Korrektur zu ermöglichen, wird der Zusatzstrom Ik unabhängig von Io im Schwingungstakt zerhackt und dem LC-Kreis separat über einen programmierbaren Polwender 4 in der geeigneten Phasenlage zugeführt.

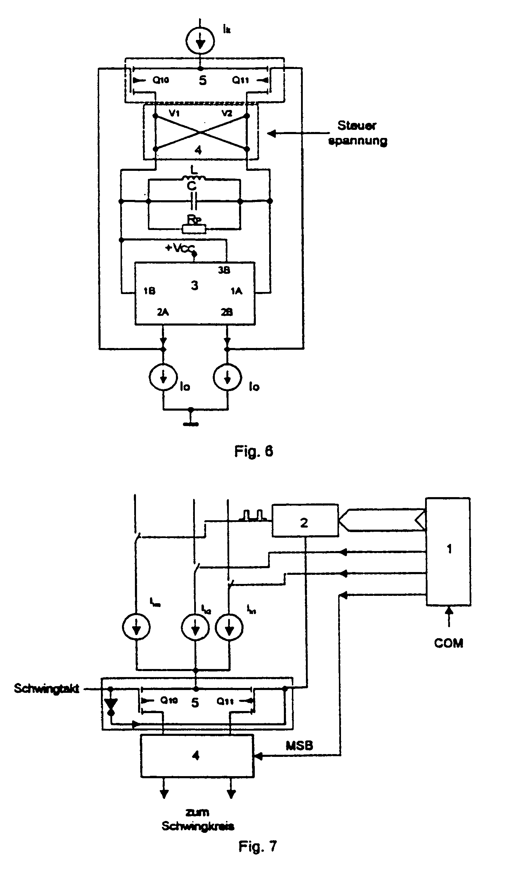

In **Figur 6** ist das Konzept des Schaltungsabgleichs mittels eines auf den Schwingkreis eingespeisten, mit der Schwingfrequenz getakteten Korrekturstroms Ik detailliert gezeigt. Der programmierbare Polwender 4 vertauscht die beiden Verbindungen V1,V2 des mit den MOS-Transistoren Q10,Q11 gebildeten Zerhackers 5 mit der Steuerspannung zum LC-Schwingungskreises und legt damit das Vorzeichen der Korrektur fest. Mit 1A, 1B, 2A, 2B und 3B sind die Ein- bzw. Ausgänge des mittels den voran diskutierten Figuren hergeleiteten Oszillatorkerns bezeichnet.

In Erweiterung des erfinderischen Konzepts wird der angestrebte "digitale" Abgleich der Toleranzen durch einen ganzen Set solcher Stromquellen mit binärer Staffelung, die aus einem einmal programmierbaren Festwertspeicher abgeleitet sind, durchgeführt. Dabei sind nur die höchstgewichteten Bits explizit als entsprechende Stromquellen ausgebildet; die niedrigsten Bitgewichte werden mittels einem Pulsdichtemodulator (wobei der Schwingkreis für die erforderliche nachfolgende Mittelung der Schwingamplitude sorgt), gebildet.

**Figur 7** zeigt die Erzeugung eines solchen Korrekturstroms mittels D/A-Wandler aus einem programmierbaren Festwertspeicher 1. Das MSB (most significant bit) steuert über den Polwender 4 das Vorzeichen der Korrektur. Die nächst niedrigen Bits schalten entsprechend binär gestufte Stromquellen Iₖ₁ und Iₖ₂ und so fort. Die niedrigsten Bits steuern über einen Pulsdichtemodulator 2 eine weitere Stromquelle Iₖₘ. Sie erzeugt einen der Pulsdichte proportionalen mittleren Korrektur-Steuersiromanteil. Die Summe aller Teilströme Iₖ₁,Lₖ₂ ... Iₖₘ ... wird dem Oszillatorkern 3 (siehe Figur 6) über den Zerhacker 5 und dem oben erwähnten Polwender 4 in der geeigneten Phasenlage zugeführt. Der Festwertspeicher 1 wird bspw. über einen seriellen Link (COM) programmiert. Dabei wird eine der bekannten Methoden der Serie/Parallel-Umsetzung angewendet. Damit ist ein digitaler Abgleich der Schaltung realisiert.

Diese gemischte Form der D/A Wandlung zur Erzeugung des Korrekturstroms wurde bei einer gebauten Versuchsschaltung aus Gründen der beschränkten Präzision der digitalen Stufung der Teilströme bei der Herstellung gewählt; es ist jedoch auch jede andere Form eines statischen D/A Wandlers brauchbar. Die durch die Mittelung der Strombeiträge des Pulsdichtemodulators bedingten Schwankungen beim dem zeitlich sich ändernden Signal nachfolgenden Amplitudenvergleich werden durch ein zusätzliches Filter nach dem geschalteten Vergleicher 6 eliminiert.

Auch die Realisierung einer Schalthysterese kann mit Hilfe eines kleinen, einstellbaren Zusatzstroms erfolgen. Zu diesem Zweck wird dieser Strom, abhängig von der Stellung des Ausgangs- (Distanz-) schalters, so zu- oder weggeschaltet, dass der Schaltpunkt im Sinne einer Hysterese von der Richtung der Dämpfungsänderung abhängig wird. Mit der Programmierung des Stromwerts ab internem Festwertspeicher oder durch Beschaltung eines Pins kann die Hystereseweite bei der Fertigstellung der Schaltung eingestellt werden.

Die p- und n-Kanal Transistoren in den Fig. 1 bis 7 können selbstverständlich bei entsprechender Umkehrung der Polarität der Speisequellen gegeneinander ausgewechselt werden.

## Patentansprüche

1. Verfahren zur Messung der Dämpfung eines elektrischen LC-Schwingungskreises, wobei auf dem Schwingungskreis eine Schwingspannung erzeugt wird, die proportional zum Dämpfungswiderstand des LC-Schwingungskreises und zu einem Steuerstrom ist, **dadurch gekennzeichnet, dass** der Steuerstrom als zu einer Referenzspannung (U_{REF}) proportionaler und zu einem Ableitwiderstand (R_{P}*) umgekehrt porportionaler Strom erzeugt und durch Anpassung des Wertes des Ableitwiderstandes (R_{P}*) so eingestellt wird, dass die Amplitude der Schwingspannung über dem LC-Kreis gleich der Referenzspannung (U_{REF}) ist.

2. Verfahren nach Anspruch 1, **dadurch gekennzeichnet, dass** der Steuerstrom aus der Summe oder Differenz mehrerer Teilströme gebildet wird.

3. Verfahren nach Anspruch 2, **dadurch gekennzeichnet, dass** der Steuerstrom aus einem fixen Grundanteil und der Summe einer Vielzahl von Teilströmen (Iₖ₁, Iₖ₂...... Iₖₘ) gebildet wird, welche programmiert zu- oder weggeschaltet werden können.

4. Anregungsschaltung (3) für einen elektrischen LC-Schwingungskreis mit Mitteln zur Messung der Dämpfung dieses Schwingungskreises, aufweisend Mittel zum Erzeugen einer Schwingspannung auf dem Schwingungskreis, die proportional zum Dämpfungswiderstand des LC-Schwingungskreises und zu einem der Anregungsschaltung zugeführten Steuerstrom ist, **dadurch gekennzeichnet, dass** die Anregungsschaltung Mittel zum Einspeisen einer Referenzspannung (U_{REF}) über einen Ableitwiderstand (R_{P}*) aufweist, wobei der Steuerstrom proportional zur Referenzspannung und umgekehrt proportional zum Ableitwiderstand (R_{P}*) ist, und dass die Schwingspannung und die Referenzspannung (U_{REF}) einem Vergleicher (6) zugeführt sind und die am Ausgang des Vergleichers (6) anstehende resultierenden Differenz einen elektrischen oder elektronischen Schalter betätigt.

5. Vorrichtung zur Messung der Distanz von einem elektrisch leitenden Objekt mittels Dämpfung eines elektrischen LC-Schwingungskreises nach einem der Verfahrensansprüche 1 bis 3, aufweisend einen Schwingkreis und eine Anregungsschaltung nach Anspruch 4, wobei der Schwingungskreis (LC) an die ihn anregende Anregungssschaltung (3) angeschlossen ist, welche zur Erzeugung einer Schwingspannung ausgebildet ist, die zum effektiven Därripfungswiderstand des Schwingungskreises und zu dem in die Anregungsschaltung (3) eingespeisten Steuerstrom proportional ist, wobei die Vorrichtung weiter die Mittel zur Erzeugung des Steuerstroms aufweist und wobei der Schaltpunkt des elektrischen oder elektronischen Schalters mit Hilfe des Steuerstroms bzw. des Ableitwiderstandes (R_{P}*) auf eine vorgegebene Messdistanz einstellbar ist.

6. Vorrichtung nach Anspruch 5, **dadurch gekennzeichnet, dass** der Ableitwiderstand (R_{P}*) zuschaltbar ist und dass Mittel vorhanden sind, die einen Steuergleichstrom aus einem Grundanteil und einem oder mehreren zusätzlichen Strömen (Iₖ₁,Iₖ₂) erzeugen mit denen die Lage des Schaltpunkts feinkorrigiert werden kann.

7. Vorrichtung nach Anspruch 6, **dadurch gekennzeichnet, dass** durch Mittel in der Schaltung ein Zusatzstrom einem über einen digitalen Festwertspeicher (1) programmierbaren D/A-Wandler entnehmbar ist, der zur Korrektur eventueller Komponenten- und Fabrikationstoleranzen dient, wobei der Festwertspeicher beim Endabgleich der Schaltung über eine serielle Schnittstelle programmierbar ist.

8. Vorrichtung nach Anspruch 7, **dadurch gekennzeichnet, dass** der Festwertspeicher (1) einen Ausgang hochgewichteten Bits und einen Ausgang mit niedriggewichteten Bits aufweist und dass der Ausgang mit den hochgewichteten Bits aus dem über den D/A-Wandler in entsprechend binär gewichtete Korrektur-Stromquellen (Iₖₙ) und der Ausgang mit den niedriggewichteten Bits mittels eines Pulsdichtemodulators (2) in einen entsprechenden mittleren Korrekturstrom (Iₖₘ) gewandelt werden, und dass Zuschaltelemente für diese Ströme vorhanden sind, durch welche die Summe dieser Ströme zum Schaltungsabgleich einsetzbar ist.

9. Vorrichtung nach Anspruch 6, 7 oder 8, **dadurch gekennzeichnet, dass** durch Mittel in der Schaltung ein geeignet mit der Betriebstemperatur variierender Zusatzstrom (Ik) erzeugbar ist, mit welchem die Abhängigkeit des Schaltpunkts von der Betriebstemperatur kompensierbar ist.

10. Vorrichtung nach einem der Ansprüche 5 bis 9 **gekennzeichnet durch** eine in den Vergleicher (6) eingespeiste Spannungsquelle U_{T}(T) zur Temperaturkompensation des Schaltpunkts.

11. Vorrichtung nach einem der Ansprüche 5 bis 10, **dadurch gekennzeichnet, dass** alle Funktionsteile mit Ausnahme des LC-Schwingungskreises und des zuschaltbaren Widerstandes auf einem Chip integriert sind.

12. Vorrichtung nach Anspruch 6, **dadurch gekennzeichnet dass** zur Erzeugung einer Schalthysterese ein von der Stellung des Schalters abhängiger, einstellbarer Zusatzstrom zu- oder wegschaltbar ist.

## Claims

1. A method for the measurement of the damping of an LC-oscillating circuit, wherein an oscillation voltage is generated across the LC-oscillating circuit, which oscillation voltage is proportional to the damping resistance of the LC-oscillating circuit and to a control current, **characterized in that** the control current is generated as a current proportional to a reference voltage (U_{REF}) and inversely proportional to a shunting resistor (R_{P}*) and is adjusted in such a manner, that the amplitude of said oscillation voltage across the LC-oscillating circuit is equal to the reference voltage (U_{REF}).

2. A method according to claim 1, **characterized in that** the control current is the sum of, or difference between, several partial currents.

3. A method according to claim 1, **characterized in that** the control current is generated by a fixed basic portion and a set of additional partial currents (Iₖ₁,Iₖ₂.......,Iₖₘ), which may be programmed to be connected or disconnected.

4. An exciting circuit (3) Device for an electric LC-oscillating circuit with means to measure the damping of this oscillation circuit, comprising means to generate an oscillation voltage across the oscillation circuit, which is proportional to the damping resistance of the LC-oscillating circuit and to a control current supplied to the exciting circuit, **characterized in that** the exciting circuit comprises means to apply a reference voltage (U_{REF}) to a shunting resistor (R_{P}*), wherein the control current is proportional to the reference voltage (U_{REF}) and inversely proportional to the shunting resistor (R_{P}*), and that the oscillation voltage and the reference voltage (U_{REF}) are fed into a comparator (6) and the resulting difference emerging from the comparator (6) operates an electric or electronic switch.

5. A device for measuring the distance from an electrically conductive object by means of damping an LC-oscillating circuit, according to any one of claims 1 to 3, comprising an oscillating circuit and an exciting circuit according to claim 4, wherein the oscillating circuit (LC) is connected to the exciting circuit (3), which is designed to generate an oscillation voltage proportional to the actual damping resistance of the oscillating circuit and to the control current supplied to the exciting circuit (3), wherein the device further comprises the means to generate the control current and wherein the switching point of the electric or electronic switch can be adjusted to a predefined object distance with the aid of the control current or the shunting resistor (R_{P}*).

6. A device according to claim 5, **characterized in that** the shunting resistor (R_{P}*) can be switched on, and that there are means to generate a control DC from a fixed basic portion and one or more additional currents (Iₖ₁,Iₖ₂), with which the switching point can be fine-tuned

7. A device according to claim 6, **characterized in that** means in the exciting circuit permit the extraction of a supplementary current from a D/A converter, the converter being programmable via a digital constant value memory drive (1) serving the correction of potential component and manufacturing tolerances, wherein the constant value memory is programmable through a serial interface during final adjustment of the exciting circuit.

8. A device according to claim 7, **characterized in that** the constant value memory (1) comprises an output of significant bits and an output of insignificant bits and that the output of significant bits is converted into correspondingly binary weighted correction current sources (Iₖₙ) via the D/A converter and the output of insignificant bits is converted into a correspondingly average correction current (Iₖₘ) by means of a pulse density modulator (2), and that there are switch elements for these currents, so that the sum of these currents can be used to adjust the circuit..

9. A device according to claim 6, 7, or 8, **characterized in that** an additional current (Iₖ), appropriately varying with the operating temperature, can be generated by the means in the circuit, by which additional current the temperature dependence of the switching point can be compensated.

10. A device according to any one of claims 5 to 9, **characterized in that** a voltage source U_{T}(T) is fed into the comparator (6) for the temperature-compensation of the switching point.

11. A device according to any one of claims 5 to 10, **characterized in that** all functional components, with the exception of the LC-oscillating circuit and the shunting resistor, are integrated on one single chip.

12. A device according to claim 6, **characterized in that** in order to generate a switching hysteresis, an additional current, adjustable and dependent on the position of the switch, can be connected or disconnected.

## Revendications

1. Procédé de mesure de l'amortissement d'un circuit électrique oscillant LC, dans lequel une tension oscillante proportionnelle à la résistance d'amortissement du circuit oscillant LC et à un courant de commande est produite sur le circuit oscillant,
**caractérisé en ce que**
le courant de commande est produit sous la forme d'un courant proportionnel à une tension de référence (U_{REF}) et inversement proportionnel à une résistance de fuite (Rₚ^{*}) et est ajusté par adaptation de la valeur de la résistance de fuite (Rₚ^{*}) de telle sorte que l'amplitude de la tension oscillante aux bornes du circuit LC soit identique à la tension de référence (U_{REF}).

2. Procédé selon la revendication 1, **caractérisé en ce que** le courant de commande est formé de la somme et de la différence de plusieurs courants partiels.

3. Procédé selon la revendication 2, **caractérisé en ce que** le courant de commande est formé d'une partie de base fixe et de la somme de plusieurs courants partiels (Iₖ₁, Iₖ₂, ..., Iₖₘ) qui peuvent être branchés ou débranchés de manière programmée.

4. Circuit d'excitation (3) pour circuit électrique oscillant LC, présentant des moyens de mesure de l'amortissement de ce circuit oscillant et présentant des moyens qui forment sur le circuit oscillant une tension oscillante proportionnelle à la résistance d'amortissement du circuit oscillant LC et à un courant de commande apporté au circuit d'excitation,
**caractérisé en ce que**
le circuit d'excitation présente des moyens d'application d'une tension de référence (U_{REF}) aux bornes d'une résistance de fuite (Rₚ^{*}), le courant de commande étant proportionnel à la tension de référence et inversement proportionnel à la résistance de fuite (Rₚ^{*}) et
**en ce que** la tension oscillante et la tension de référence (U_{REF}) sont apportées à un comparateur (6), la différence ainsi obtenue à la sortie du comparateur actionnant un commutateur électrique ou électronique.

5. Dispositif de mesure de la distance d'un objet électriquement conducteur par amortissement d'un circuit électrique oscillant LC selon l'une des revendications 1 à 3, et présentant un circuit oscillant et un circuit d'excitation selon la revendication 4,
le circuit oscillant (LC) étant raccordé au circuit d'excitation (3) qui l'excite et qui est configuré pour produire une tension oscillante proportionnelle à la résistance effective d'amortissement du circuit oscillant et au courant de commande injecté dans le circuit d'excitation (3),
le dispositif présentant en outre des moyens de production du courant de commande, le point de commutation du commutateur électrique ou électronique pouvant être ajusté à une distance de mesure prédéterminée à l'aide du courant de commande et de la résistance de fuite (Rₚ^{*}).

6. Dispositif selon la revendication 5, **caractérisé en ce que** la résistance de fuite (Rₚ^{*}) peut être branchée et **en ce que** le dispositif présente des moyens qui produisent un courant continu de commande constitué d'une partie de base et d'un ou plusieurs courants supplémentaires (Iₖ₁, Iₖ₂) par lesquels la position du point de commutation peut être corrigée finement.

7. Dispositif selon la revendication 6, **caractérisé en ce qu'**il présente des moyens qui permettent de prélever dans le circuit un courant supplémentaire vers un convertisseur numérique-analogique qui peut être programmé par l'intermédiaire d'une mémoire numérique (1) à valeurs fixes et qui sert à corriger d'éventuelles tolérances sur les composants et tolérances de fabrication, la mémoire à valeurs fixes pouvant être programmée par l'intermédiaire d'une interface série lors de l'étalonnage final du circuit.

8. Procédé selon la revendication 7, **caractérisé en ce que** la mémoire (1) à valeurs fixes présente une sortie pour bits à haute pondération et une sortie pour bits à basse pondération, **en ce que** la sortie qui présente les bits à haute pondération est convertie par le convertisseur numérique-analogique en sources de courant de correction (Iₖₙ) à pondération binaire correspondante et la sortie qui présente les bits à basse pondération est convertie au moyen d'un modulateur (2) de densité d'impulsions en un courant moyen de correction (Iₖₘ) correspondant, et **en ce que** des éléments de raccordement de ces courants, par lesquels la somme de ces courants peut être utilisée pour l'étalonnage du circuit, sont prévus.

9. Dispositif selon les revendications 6, 7 ou 8,
**caractérisé en ce que** des moyens prévus dans le circuit permettent de produire un courant supplémentaire (Iₖ) qui varie en fonction de la température de fonctionnement et qui permet de compenser la dépendance du point de commutation vis-à-vis de la température de fonctionnement.

10. Procédé selon l'une des revendications 5 à 9,
**caractérisé par** une source qui injecte une tension U_{T}(T) dans le comparateur (6) pour assurer la compensation de la température du point de commutation.

11. Dispositif selon l'une des revendications 5 à 10, **caractérisé en ce qu'**à l'exception du circuit oscillant LC et de la résistance apte à être raccordée, toutes les parties fonctionnelles sont intégrées sur une puce.

12. Dispositif selon la revendication 6, **caractérisé en ce que** pour former une hystérèse de commutation, un courant supplémentaire ajustable et dépendant de la position du commutateur peut être branché ou débranché.
